(19) **Europäisches Patentamt**
**European Patent Office**
**Office européen des brevets**

(11) **EP 4 776 067 A1**

(12) **EUROPEAN PATENT APPLICATION**

(43) Date of publication:
**15.07.2026 Bulletin 2026/29**

(21) Application number: **25150768.7**

(22) Date of filing: **08.01.2025**

(51) International Patent Classification (IPC):
*G03F 7/00* *(2006.01)*

(52) Cooperative Patent Classification (CPC):
**G03F 7/705; G03F 7/70616; G03F 7/706841**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ASML Netherlands B.V.**
**5500 AH Veldhoven (NL)**

(72) Inventors:
• **ONOSE, Alexandru**
**5500 AH Veldhoven (NL)**
• **BOTARI, Tiago**
**5500 AH Veldhoven (NL)**
• **VENSELAAR, Joannes Jitse**
**5500 AH Veldhoven (NL)**
• **BATISTAKIS, Chrysostomos**
**5500 AH Veldhoven (NL)**
• **VAN KRAAIJ, Markus Gerardus Martinus Maria**
**5500 AH Veldhoven (NL)**

(74) Representative: **ASML Netherlands B.V.**
**Corporate Intellectual Property**
**P.O. Box 324**
**5500 AH Veldhoven (NL)**

(54) **SELFGUIDED DIFFUSION MODELS FOR UNPAIRED AND WEAKLY PAIRED DATA WITH APPLICATIONS IN THE MANUFACTURE OF INTEGRATED CIRCUITS**

(57) A computer-implemented method of processing first metrology data of a patterned portion of a substrate patterned using a wafer processing apparatus to generate predicted second metrology data of the, or another corresponding, patterned portion of the substrate, the first metrology data comprising metrology data from a first metrology domain which obtains metrology data using a first metrology process. The method comprises obtaining the first metrology data of the patterned portion of the substrate, and generating predicted second metrology data of the patterned portion of the substrate, or of the corresponding patterned portion of the substrate, based on the output of a first trained diffusion model conditioned on the first metrology data, the predicted second metrology data comprising predicted metrology data from a second metrology domain which obtains metrology data using a second metrology process.

## Fig. 9A

EP 4 776 067 A1

## Description

FIELD

The present invention relates to systems and methods for processing metrology data from a first metrology domain of a patterned portion of a substrate (e.g. a wafer of semiconductor material) to generate predicted metrology data from a second metrology domain of the, or another corresponding, patterned portion of the substrate. The present invention also relates to systems and methods for jointly training a first diffusion model to process metrology data from the second metrology domain, and a second diffusion model to process metrology data from the first metrology domain. The present invention also relates to systems and methods for training a style transfer model to process metrology data from a first metrology domain to predict corresponding metrology data from a second metrology domain, and to systems and methods for jointly training a first style transfer model to process metrology data from a first metrology domain and a second style transfer model to process metrology data from a second metrology domain.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In the manufacture of integrated circuits, it is desirable to provide computational models which can reliably map data between two domains (e.g. a model that maps data from an initial domain A to data from a corresponding remapping domain B or vice versa). Such domain-to-domain mapping models can be used to predict information that is not readily available from metrology data in a single domain, e.g. information that is resource or time intensive to acquire. This can be helpful in predicting and mitigating problems that may occur during the manufacturing process.

For example, it is generally desirable to adjust process parameters (e.g. scanner settings or conditions, etch process parameters, and the like) which specify the manufacturing process to improve performance and yield of the semiconductor devices made with the same manufacturing process. This can be achieved by inspecting a substrate (i.e. to measure properties of the patterned structure) that has been patterned using the lithographic apparatus, e.g. to determine whether the produced pattern accurately resembles the intended design. More specifically, a metrology system (e.g. optical metrology systems, scanning electron microscopes (SEM), soft x-ray metrology systems, and the like) can be used to acquire metrology data (any measured signals such as image(s)) of the patterned substrate. The acquired metrology data is then further processed using specialised algorithms to infer an estimate of one or more parameters of interest which can be further processed to update the process parameters. However, sometimes it is undesirable to acquire the metrology data, e.g. because the metrological process is resource intensive, time intensive, destructive to the substrate, or the like. In such cases, it is advantageous to be able to predict the desired metrology data from more readily available data which is often from a different domain, e.g. to predict SEM signals from optical images, to predict ADI (after development inspection) data from AEI (after etch inspection) data, and the like. It is therefore desirable to provide improved techniques for performing domain to domain mapping of metrology data.

SUMMARY

The present invention aims to provide new and useful methods and systems for processing first metrology data of a patterned portion of a substrate patterned using a wafer processing apparatus to generate predicted second metrology data of the patterned portion of the substrate, or another corresponding, patterned portion of the substrate. The first metrology data comprises metrology data from a "first metrology domain" and the predicted second metrology data comprises predicted metrology data from a "second metrology domain" (i.e. from a different metrology domain than the first metrology domain). Thus, in broad terms, the methods and systems described in this specification enable mapping metrology data from one domain to another domain.

The term "metrology domain" refers to metrology data obtained by using a respective metrology process, i.e. a metrology process defines a corresponding metrology domain. Specifically, the first metrology domain obtains metrology data using a first metrology process, and the second metrology domain obtains metrology data using a second, different metrology process. The term "metrology data" generally refers to data comprising (real or predicted) data output generated by a respective metrology system that implements the respective metrology process using one or more sensors to collect measurements (measurement signals) from an inspection target. The measured signals may be image(s). More generally, the measured signals may be any 1-dimensional, 2 dimensional or even higher dimensional data. As an example, the first metrology data may be generated by inspecting the patterned portion of the substrate using a first metrology system that implements the first metrology process, and the predicted second metrology data may be a prediction of metrology data that would have been generated by inspecting the patterned portion (or another corresponding pattern portion) using a second metrology system implementing the second metrology process (further examples are described below).

In general terms, the invention proposes a method that comprises obtaining the first metrology data of the patterned portion of the substrate (the first metrology data is from the first domain), and generating predicted second metrology data of the patterned portion of the substrate, or of the corresponding patterned portion of the substrate, based on the output of a (first) trained diffusion model (i.e. a trained diffusion-based generative neural network) conditioned on the first metrology data (the predicted second metrology data comprises predicted metrology data from the second metrology domain). The first trained diffusion model may generate the output upon processing an input (e.g. a random input, or as described below, an input of predicted metrology data from the second metrology domain which is to be improved) while being conditioned on the first metrology data.

In some implementations, the first diffusion model has been trained based on the output of the first diffusion model when conditioned on metrology data in the first metrology domain which was generated based on the output of a second trained diffusion model conditioned on training metrology data from the second metrology domain. The second trained diffusion model has been trained to predict metrology data in the first metrology domain from metrology data in the second metrology domain (i.e. the second diffusion model performs a reversed domain-to-domain mapping compared to the first diffusion model). Using the second trained diffusion model in the training of the first diffusion model eases the requirements on the training database by allowing training using "weakly paired" training metrology data items instead of requiring "fully paired" training metrology data items (as described below in more detail).

The term "fully paired" data refers to a situation in which a given location on a substrate is measured using both a first metrology process and a second metrology process, to generate respective data items. The term "weakly paired" training metrology data items refers to a metrology data item from the first domain and a metrology data item from the second domain which do not relate to the same location of the patterned substrate but do relate to nominally identical locations (i.e. locations where a semi-conductor structure has been formed based on identical design data). Optionally, "weakly paired" data may employed in embodiments of the current disclosure may relate to locations on the substrate which are meet a proximity criterion (i.e. are no further than a distance threshold from each other). This is motivated by an assumption that the substrate manufacturing process will image nearby locations in a similar way. For both the cases of "weakly paired" and "fully paired" data, the data items from the first and second domain relate to substrate(s) produced by the same process parameters, though optionally at different stages of the production process. Obtaining fully paired training metrology data items is often expensive, impractical or even impossible, while weakly paired training metrology data items are more readily available.

The first diffusion model conditioned on the first metrology data may process an input data item, and the step of generating predicted second metrology data may be performed a plurality of times using different respective randomly selected input data items to generate a corresponding plurality of corresponding items of predicted second metrology data. In this way, a plurality of second metrology data items is generated that represent an approximation of a distribution of metrology data items from the second domain consistent with the first metrology data.

In some implementations, there may be an iterative process of, in a first iteration, generating initial candidate second metrology data (e.g. from a random input), followed by one or more iterations of improving the candidate second metrology data produced in the previous iteration, to improve its consistency with the metrology data. More specifically, in some cases, generating predicted second metrology data of the patterned portion

or the corresponding patterned portion of the substrate based on the output of a first trained diffusion model conditioned on the first metrology data may comprise at least one iteration of processing, by the first diffusion model conditioned on the first metrology data, an input to the first diffusion model comprising current candidate second metrology data, and based on the output of the first diffusion model generating updated candidate second metrology data. The predicted second metrology data may be generated based on the updated candidate second metrology data produced in the last iteration.

In other cases, the method may further comprise obtaining third metrology data of the patterned portion, or the corresponding patterned portion. The third metrology data may comprise metrology data from the second metrology domain. The step of generating predicted second metrology data may comprise for each of a plurality of iterations processing, by the first diffusion model conditioned on respective conditioning metrology data for the iteration, an input to the first diffusion model comprising current candidate second metrology data, based on the output of the first diffusion model generating updated candidate second metrology data. The predicted second metrology data may be generated based on the updated candidate second metrology data produced in the last iteration. For an initial iteration, the conditioning metrology data for the iteration may be the first metrology data, and for at least one subsequent iteration, the conditioning metrology data for the iteration may be generated based on the output of the second diffusion model conditioned on the third metrology data (i.e. in at least one iteration, the first diffusion model is "guided" by the output of the second diffusion model).

The first diffusion model may be conditioned on other data in addition to the conditioning metrology data. This data may encode any available information about the first and second domain and/or the patterning process, or any available information which is used to define the input to the first diffusion model. For example, in each iteration, the first diffusion model may be conditioned on a variable indicating the iteration. This may be useful since in later iterations the magnitude of the noise described by the output of the first diffusion model may be less.

In these cases, each of the plurality of iterations may further comprise processing, by the second diffusion model conditioned on respective conditioning metrology data for the iteration, an input to the second diffusion model comprising current candidate fourth metrology data from the first metrology domain, and based on the output of the second diffusion model generating updated candidate fourth metrology data from the first metrology domain. The method may further comprise generating predicted fourth metrology data from the first metrology domain based on the updated candidate fourth metrology data produced in the last iteration. For the initial iteration, the second diffusion model may be conditioned on the third metrology data, and for each subsequent iteration, the first diffusion model may be conditioned on the updated candidate fourth metrology data generated for a previous iteration (e.g. the directly preceding iteration), and the second diffusion model may be conditioned on the updated candidate second metrology data generated for a previous iteration. Thus, diffusion models are "cross-linked" to "guide" each other over multiple iterations. This "cross-linking" of the complementary diffusion models allows obtaining two statistically correlated samples from the first and second domain are obtained (second and fourth metrology data).

For each subsequent iteration, the first diffusion model may be conditioned on conditioning metrology data generated from a plurality of items of updated candidate fourth metrology data generated in a corresponding plurality of previous iterations, and the second diffusion model may be conditioned on conditioning metrology data generated from a plurality of items of updated candidate second metrology data generated in a corresponding plurality of previous iterations.

In some implementations, the method may further comprise a step of processing the predicted second metrology data (and or the predicted fourth metrology data) to generate one or more control actions for controlling the wafer processing apparatus to pattern additional substrates or to further pattern said substrate. The wafer processing apparatus may be controlled based on the generated one or more control actions apparatus to pattern additional substrates or to further pattern said substrate.

The patterned portion of the substrate may comprise a plurality of nominally identical targets, and the first metrology data is obtained by obtaining a respective metrology data item for each of the plurality of nominally identical targets. The first metrology data may then be generated based on the metrology data items of the plurality of nominally identical targets. In some case, the first metrology data may be generated based on statistical values obtained by statistical analysis of the metrology data items of the plurality of nominally identical targets. More specifically, the first metrology data may be one of the metrology data items of the plurality of nominally identical targets which is selected based on the statistical values. The first metrology data may be selected as one having properties which obey a similarity criterion with respect to the statistical values, or may be generated based on a mean or median of the metrology data items of the plurality of nominally identical targets.

Alternatively, the patterned portion of the substrate may comprise a plurality of nominally identical targets, and the first metrology data may be metrology data for one of the plurality of nominally identical targets.

In some implementations, the first metrology data may be metrology data of the patterned portion of the substrate at earlier step during a manufacturing process (e.g. an after development inspection step), and the predicted second metrology data is a prediction of metrology data of the or a corresponding patterned portion at a later step during the manufacturing process (e.g. an after etch inspection step).

The first metrology data may be metrology data of the patterned portion of the substrate generated by inspecting the patterned portion using a first metrology system, and the predicted second metrology data may be a prediction of metrology data which would have been generated by inspecting the patterned portion using a second metrology system. The first and second metrology systems may be based on any suitable metrological process, e.g. based on one or more of optical visible light metrology, SXR (soft x-ray) metrology or high landing energy SEM (scanning electron microscope) technology (HL-SEM). In some cases, the first metrology system may be an optical metrology system, and the second metrology system may be an electron-beam metrology system.

The first metrology system may be a metrology system in a first configuration, and the second metrology system may be the first metrology system or a further metrology system in a second configuration different from the first configuration. For example, the first configuration of the metrology system may specify a first wavelength of the metrology system, and the second configuration of the metrology system may specify a second wavelength of the metrology system or the further metrology system.

In some implementations, the first metrology data may be metrology data of a first patterned portion of the substrate, and the predicted second metrology data may be a prediction of a second patterned portion of the substrate. In some cases, the first and second patterned portion of the substrate were fabricated based on identical design data.

The first metrology data may comprise image data. The first metrology data may comprise after development inspection data or after etching inspection data.

In some implementations, the wafer processing apparatus may be a lithographic apparatus. In other implementations, the wafer processing apparatus may be an etching apparatus or a deposition apparatus.

In another aspect, the invention proposes a method of jointly training a first and a second diffusion model. The first diffusion model is trained to process, when the first diffusion model is conditioned on metrology data from a first metrology domain comprising metrology data obtainable by using a first metrology process, input metrology data from a second metrology domain comprising metrology data obtainable by using a second metrology process to generate noise data indicative of a divergence between the input metrology data and predicted metrology data from the second metrology domain (e.g. according to a similarity metric such as Euclidean distance), and the second diffusion model is trained to process, when the second diffusion model is conditioned on metrology data from the second metrology domain, input metrology data from the first metrology domain to generate respective noise data indicative of a divergence between the respective input metrology data and predicted metrology data from the first metrology domain. The method uses a training database of training items which each comprises a tuple comprising training metrology data from the first metrology domain for a patterned portion of a substrate patterned using a wafer processing apparatus, and training metrology data from the second metrology domain for a nominally identical patterned portion of the said substrate. The method comprises, for each tuple, performing a plurality of iterations, at each iteration processing, by the first diffusion model conditioned on respective conditioning metrology data for the iteration, respective input metrology data for the iteration and generating respective output metrology data for the iteration based on the output of the first trained diffusion model, processing, by the second diffusion model conditioned on respective conditioning metrology data for the iteration, respective input metrology data for the iteration and generating respective output metrology data for the iteration based on the output of the second trained diffusion model, and iteratively modifying one or more numerical parameters of the first and the second diffusion model to reduce i) a measure of the divergence between the input metrology data and the output metrology data for the iteration for the first diffusion model, and ii) a measure of the divergence between the input metrology data and the output metrology data for the iteration for the second diffusion model. The input metrology data for the first diffusion model comprises the metrology data from the first metrology domain for the tuple or the output metrology data generated based on the output of the first diffusion model for a previous iteration, and the input metrology data for the second diffusion model comprises the metrology data from the second metrology domain for the tuple or the output metrology data generated based on the output of the second diffusion model for a previous iteration. At least for one iteration, the conditioning metrology data for the first diffusion model is generated based on the output of the second diffusion model for a previous iteration, and the conditioning metrology data for the second diffusion model is generated based on the output of the first diffusion model for a previous iteration.

Advantageously, jointly training the first and second diffusion models in the described cross-linked configuration enables the use of weakly paired training metrology data items. Further, the joint training encourages learning of maps that jointly model the mapping from the first domain to the second domain as well as the reverse mapping from the second domain to the first domain.

The conditioning metrology data for the first diffusion model may be generated based on a combination of the metrology data from the first metrology domain for the tuple and the output of the second diffusion model for a previous iteration. The conditioning metrology data for the second diffusion model may be generated based on a combination of the metrology data from the second metrology domain for the tuple and the output of the first diffusion model for a previous iteration. More specifically, the conditioning metrology data for the first diffusion model may be generated based on a weighted sum of the metrology data from the first metrology domain for the tuple and the output of the second diffusion model for a previous iteration. The conditioning metrology data for the second diffusion model may be generated based on a weighted sum of the metrology data from the second metrology domain for the tuple and the output of the first diffusion model for a previous iteration (the weights of the weighted sums may depend on the respective iteration).

For at least one training item, the tuple may comprise training metrology data from the second metrology domain that is generated by processing the corresponding training metrology data from the first metrology domain with a style transfer model configured to process metrology data from the first metrology domain to predict corresponding metrology data from the second metrology domain. The style transfer model may be jointly trained with the first and second diffusion models.

The style transfer model makes it possible to employ metrology data from different metrology domains in the case of "unpaired data". By this is meant data obtained using different metrology domains, in relation to respective locations on the substrate which are not nominally identical. Furthermore, the locations on the substrate may be locations on corresponding substrates which were generated according to different process parameters.

The invention further proposes a method of training a style transfer model to process metrology data from a first metrology domain, which obtains metrology data using a first metrology process, to predict corresponding metrology data from a second metrology domain which obtains metrology data using a second metrology process. The method uses a training database of training items which each comprises training metrology data from the first metrology domain for a patterned portion of a substrate patterned using a wafer processing apparatus, and corresponding training metrology data from the second metrology domain. The method comprises, for each training item, performing a plurality of iterations, at each iteration, processing, by the style transfer model, the metrology data from the first metrology domain for the iteration to predict corresponding metrology data from the second metrology domain, and iteratively modifying one or more numerical parameters of the style transfer model to reduce a measure of the divergence between the metrology data predicted by the style transfer model and the corresponding training metrology data from the second metrology domain for the iteration.

The invention also proposes a method of jointly training a first style transfer model and a second style transfer model. The first style transfer model is trained to process metrology data from a first metrology domain, which obtains metrology data using a first metrology process, to predict corresponding metrology data from a second metrology domain which obtains metrology data using a second metrology process. The second style transfer model is trained to process metrology data from the second metrology domain to predict corresponding metrology data from the first metrology domain. The method uses a training database of training items which each comprise training metrology data from the first metrology domain for a patterned portion of a substrate patterned using a wafer processing apparatus, and corresponding training metrology data from the second metrology domain, e.g. the two training items may be "weakly paired" or "unpaired items" of training metrology data. The joint training is implemented using a cycle generative adversarial network comprising (as generators) the first and second style transfer models, a first discriminator model configured to discriminate between the output of the first style transfer model generated when processing training metrology data from the first metrology domain and the corresponding training metrology data from the second metrology domain, and a second discriminator model configured to discriminate between the output of the second style transfer model generated when processing the output of the first style transfer model and the corresponding training metrology data.

The invention further proposes another method of jointly training a first style transfer model and a second style transfer model. The first style transfer model is trained to process metrology data from a first metrology domain, which obtains metrology data using a first metrology process, to predict corresponding metrology data from a second metrology domain which obtains metrology data using a second metrology process. The second style transfer model is trained to process metrology data from the second metrology domain to predict corresponding metrology data from the first metrology domain. The method uses a first (e.g. at least partially pre-trained) diffusion model, such as one obtained using the methods described above. The first diffusion model is configured to process, when the first diffusion model is conditioned on metrology data from the first metrology domain, input metrology data from a second metrology domain to generate noise data indicative of a divergence between the input metrology data and predicted metrology data from the second metrology domain, and uses a training database comprising a plurality of training items comprising training metrology data from the second metrology domain for a patterned portion of a substrate patterned using a wafer processing apparatus. The method comprises, for each training item obtaining a cyclic loss by processing the training metrology data for the training item using the second style transfer model to generate predicted metrology data from the first metrology domain, processing the predicted metrology data from the first metrology domain using the first style transfer model to generate predicted metrology data from the second metrology domain, and determining the cyclic loss based on a divergence between the training metrology data for the training item and the predicted metrology data from the second metrology domain. The method comprises, for each training item obtaining a diffusion loss by generating based on the output of the first diffusion model, when conditioned on the predicted metrology data from the first metrology domain generated, for the training item, by the second style transfer model, respective output metrology data for the training item, determining the diffusion loss based on a divergence between the training metrology data for the training item and the corresponding output metrology data generated based on the output of the first diffusion model. The method comprises modifying one or more numerical parameters of the first and second style transfer models based on the cyclic loss and the diffusion loss. The method may further comprise, for each training item, modifying one or more numerical parameters of the first diffusion model based on the diffusion loss.

Thus, the pre-trained diffusion models may be used to train the style transfer models which once trained can be used to further train the diffusion models.

In the explanation given above, the invention is expressed as a method, with various optional features. However, in another aspect, the invention proposes a computer program product comprising machine-readable instructions which, when the program is executed by a computer, cause the computer to carry out the method.

In another aspect, the invention proposes a computer system comprising a processor and a data storage device, the data storage device storing program instructions which, when executed by the processor, cause the processor to carry out the methods discussed above.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 illustrates the operation of a diffusion model;
- Figure 7 illustrates different types of datasets;
- Figure 8 illustrates wafer measurement procedure that generates metrology data from two different metrology domains;
- Figure 9, which is composed of Figures 9A and 9B, illustrates the operation of a two diffusion models in an embodiment of the present invention;

- Figure 10 is a flow diagram of a process which is an embodiment of the invention;
- Figure 11 is a flow diagram of a further process which is an embodiment of the invention;
- Figure 12 illustrates the process of Figure 11;
- Figure 13 illustrates the processes of Figures 10 and 11;
- Figure 14 illustrates a process for training the diffusion models of Figure 9, and
- Figure 15 illustrates an optional process used in an embodiment of the invention.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

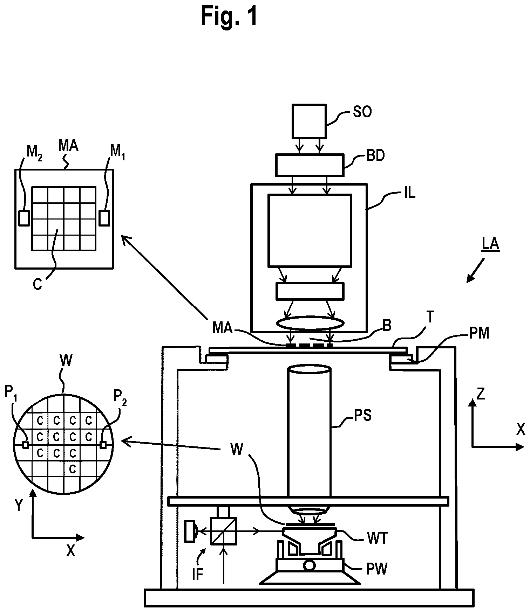

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

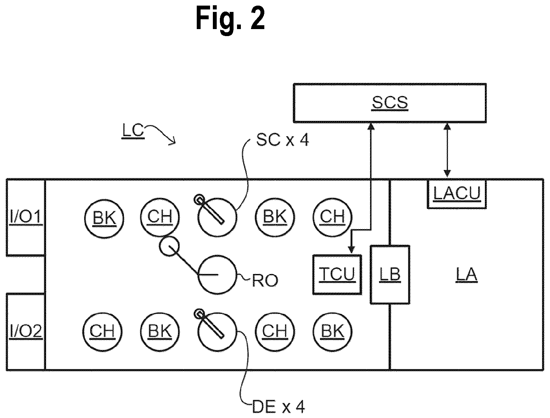

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

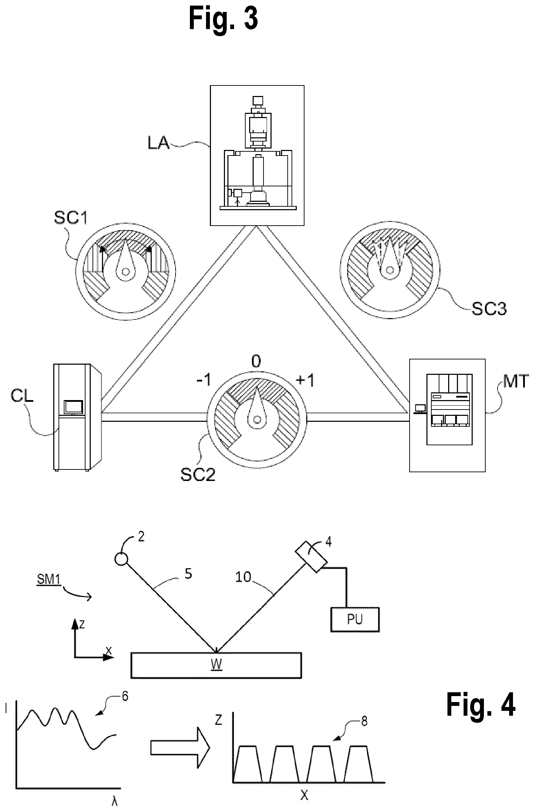

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) -typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic patterning apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

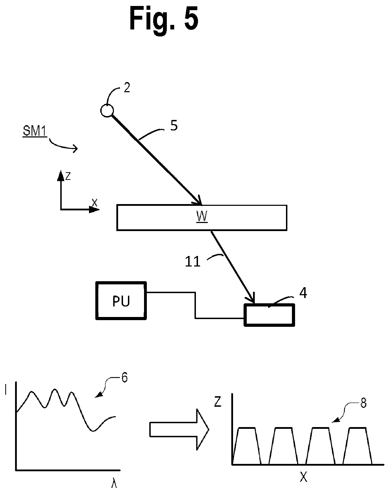

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

A metrology system can be used to inspect a patterned substrate, e.g. to determine whether the patterned substrate was fabricated correctly, and/or whether the lithographic apparatus is operating correctly or needs adjusting. The term metrology system may refer to any suitable instrument that is capable of determining relevant properties of the patterned substrate. Examples of metrology systems include image-based metrology instruments (e.g. micro diffraction based overlay metrology (uDBO) instruments, phase based overlay metrology (pDBO) instruments, optical dark-field microscopes and the like), pupil-based metrology instruments (e.g. scatterometers, soft x-ray metrology instruments), scanning electron microscopes (e.g. single beam or multi-beam SEMs), and the like.

As noted above, it is frequently desirable to be able to perform domain-to-domain mapping of metrology data, i.e. to predict metrology data from a target domain ("domain B") from acquired metrology data from an initial domain ("domain A"). As a first example, domain-to-domain mapping may be used for ADI to AEI prediction, e.g. to predict critical dimension (CD) values and defects from the metrology data associated with the lithography/resist exposure step, before the pattern is irreversibly transferred via etching to the substrate at the AEI step. In this case, domain A may be scanning electron microscope (SEM) images acquired at the ADI step, and domain B may be predicted SEM images at the AEI step. Being able to reliably predict AEI data from ADI data allows adjusting/correcting of AEI process parameters before the etching is performed, and thus improves the manufacturing yield.

As a second example, domain-to-domain mapping may be used for "cross-tool-mapping", i.e. to use metrology data of a patterned substrate acquired using one type of metrology system (e.g. an optical metrology system) to predict metrology data that would have been generated by using a metrology system of a different type (e.g. a SEM) to inspect the same patterned substrate. It is also possible that the metrology system of the domain B is of the same type as the metrology system of domain A but set in a different configuration (e.g. an optical metrology system operating at different wavelength as the optical metrology system of domain A). Cross-tool-mapping can be useful when the metrology system of the target domain is not available or resource/time-intensive.

As a third example, domain-to-domain mapping can be useful (e.g. time-saving) for "target-to-target" mapping, i.e. to use metrology data acquired of target structures (targets for short) formed in a first portion of the substrate to predict metrology data for targets in a second (i.e. different) portion of the substrate (the targets of the first and second portion may or may not be nominally identical, i.e. designed according to the same target design). For example, the targets of the first portion may be scribe lane targets of a wafer and the targets of the second portion may be in-die target of the wafer.

In the above-described examples and in other similar applications, the mapping from domain A to domain B is an "ill-posed" problem. This is because a given sample from domain A can have multiple possible outcomes in domain B. For example, there might exist multiple patterned structures that result in the same optical image (domain A) but in different SEM images (domain B). In some applications, not only the mapping from domain A to domain B but also the reversed mapping from domain B to domain A is ill-posed, i.e. in these cases there might be multiple examples from domain A that can map to the same example from domain B (i.e. there is a "many-to-many" relationship between domain A and domain B).

In some applications, deterministic physics-based mathematical/computational models may be used to implement domain mapping. However, the production of such models can lead to a high upfront cost and is typically very application specific. Instead of physics-based models, machine learning models may be used, i.e. computational models defined by learnable parameters which have been adjusted based on training data. The inventors have realised that diffusion models are particularly well suited for domain mapping, as described below in more detail.

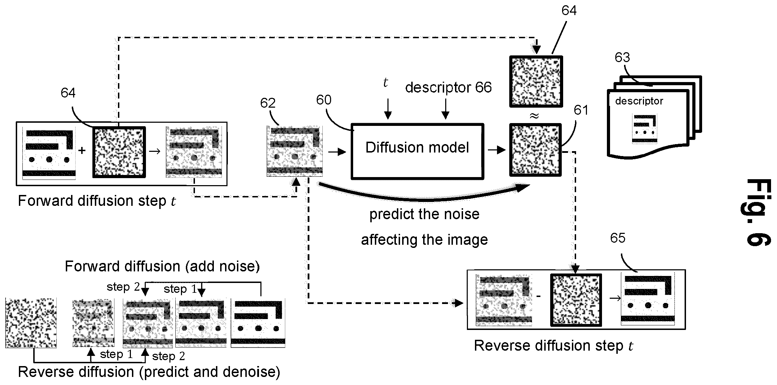

Before describing example embodiments (which employ diffusion models for domain mapping) a more general description of generative models and in particular diffusion models is provided with reference to Figure 6. By "generative network" is meant here an adaptive model defined by numerical parameters which have been iteratively trained, such that the generative model generates an output based on a joint probability distribution of a target dataset Y given an input dataset X received by the generative network. For example, the generative model, upon receiving an input dataset (e.g. an input to the generative model and any further data on which the generative model is conditioned), may generate an output which is a prediction (estimate) of the target dataset which is most likely given the input dataset. A diffusion model (e.g. diffusion model 60 in Figure 6) is a type of generative machine learning model (i.e. a model that aims to learn an approximation of the probabilistic distributions of the trained data). More specifically, the model 60 is trained to predict the noise 61 that is present in an input image 62 (e.g. a SEM image) which is input to the diffusion model 60. This is achieved by implementing a training process where a set of training instances 63 are used as starting points for a perturbation process in which noise 64 is intentionally introduced (to mimic a diffusion process in a latent space). Note that the noise 64 may be directly introduced in the "signal space", that is to images obtained by metrology rather than to transformed or encoded versions of those images, or to data the latent space. This process is called forward diffusion. Then, the diffusion model 60 is optimized to reverse such perturbed instances by reconstructing the original unperturbed instance. This is done through learning process where the model is optimized to predict the introduced perturbation 61 (i.e. an estimate of the noise 64) and thus remove it from the input image 62 to generate a de-noised image 65. In this way, the model learns to approximate the probability distribution of the real data 63 and therefore the manifold of the data. Once the model 60 is trained, the model 60 can be used to sample new instances in the learned manifold. This is done by starting with a random generated instance and applying the model 60 successive times until a stop criterion is satisfied. This process is known as reverse diffusion. The diffusion process implemented by model 60 can be guided by additional information that acts as an extra input to the model, e.g., using a descriptor 66 for content of each element in the dataset. This is referred to as conditioning the diffusion model 60. An additional value used to condition the diffusion model 60 may be an index t which indicates the level of noise in the image 62, e.g. the number of forward diffusion steps used to generate the input images 62.

Diffusion models, such as model 60, have been developed in the context of generating images, i.e. taking a large collection of images, a diffusion model is trained by applying noise to the image, which it then learns to extract. Starting with an image of random pixels, the diffusion model iteratively modifies the pixel values of an image to one that is close to the manifold of images the model was trained on. Additional descriptors are used to condition the diffusion model, to guide the model to predict images that match such description. These diffusion models have been successfully employed to generate images that match an input description. The inventors have realised that diffusion models similar to model 60 can be employed for domain mapping of metrology data.

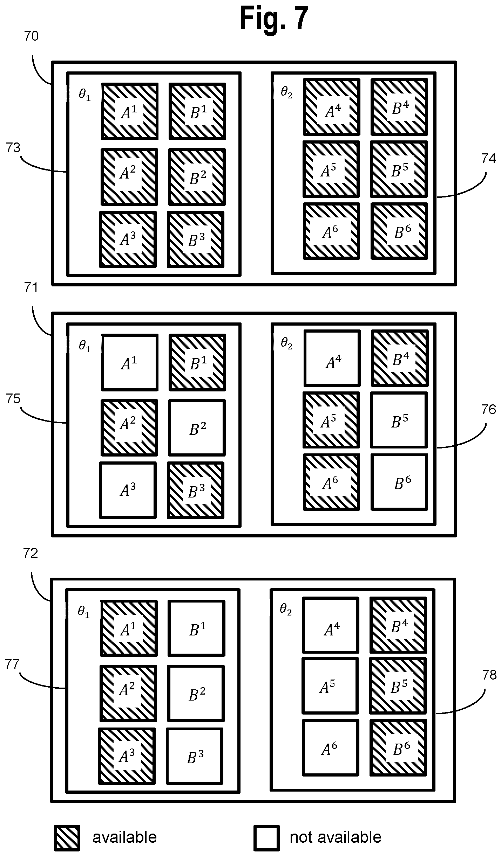

As noted above, training data is required to train machine learning models such as the above-described diffusion models. In general, appropriate training data can be generated by using respective metrology systems to inspect (training) patterned substrates to generate metrology data items from domain A and from domain B. As described below with reference Figure 7, in the context of manufacture of semiconductor devices, three "types" of training datasets can be considered: fully paired training data, weakly paired training data and unpaired training data. Before describing these different types of datasets in more detail, a mathematical framework of the metrology data generation is provided.

More specifically, an underlying generative (substrate fabrication) process $p(\theta)$ is considered from which metrology data items (from domain A or domain B) can be sampled. The process $p(\theta)$ is considered to be parametrised by a set of parameters denoted with the symbol "$\theta$". For example, the parameters "$\theta$" may specify a parametrised patterning process for patterning the substrate for which metrology data items are to be sampled (e.g. focus, dose, intended design). The underlying generative process $p(\theta)$ gives rise to a probability $p_A$ $(\theta, \zeta_A)$ for sampling data in the domain A, where $\zeta_A$ denotes a domain A specific configuration (e.g. $\zeta_A$ may specify a metrology process associated with domain A, e.g. by specifying a configuration of a metrology system that can be used to generate domain A data items). Given a sample A sampled from domain A, the probability for sampling data in domain B can be represented by $p_B(\theta, \zeta_B|A)$, where $\zeta_B$ denotes a domain B specific configuration.

As noted above, a training dataset can comprise "fully paired" training data items, "weakly paired" training data items and/or "unpaired" training data items. In general, a fully paired dataset includes corresponding pairs of metrology data items from domain A and domain B, i.e. that both elements of a pair $\{A^i, B^i\}$ are available, where $A^i$ is a sample of domain A for the "i-th" location on the substrate and $B^i$ is a corresponding sample of domain B for the "i-th" location (i.e. the same location as $A^i$) on the substrate. A weakly paired training dataset includes only one element of any pair $\{A^i, B^i\}$ but includes metrology data items from each domain generated by for the same values of the process parameters $\theta$, e.g. data items $A^i$ and $B^j$ (i.e. data items from different domains and different location on the substrate) generated using a first set of values of the process parameters $\theta_1$ are considered "weakly paired". Note that, however, that the elements of a pair $\{A^i, B^i\}$ may refer to measurements collected at different respective times during the substrate fabrication process. An unpaired training dataset includes, for each set of values of the process parameters $\theta$, either only data item from domain A or from domain B. Thus, in this case, the data items $A^i$ and $B^j$ are considered unpaired because they have been generated for different values of the process parameters $\theta$.

Figure 7 illustrates the concept of fully paired training data 70, weakly paired training data 71 and unpaired training data 72. In this example, six locations on the substrate are considered (i.e. $i = 1, ... , 6$) where the substrate at locations $i = 1, 2, 3$ has been patterned according to the process parameters $\theta_1$ and at locations $i = 4, 5, 6$ according to the parameters $\theta_2$ (e.g. the parameters $\theta_1$ may specify the patterning process for a first field of an wafer and the parameters $\theta_2$ may specify the patterning process for a second field of the wafer; i.e. in this case locations $i = 1, 2, 3$ are within the first field and locations $i = 4, 5, 6$ are within the second field of the wafer).

The fully paired training dataset 70 includes corresponding pairs of metrology data items from domain A and domain B. Specifically, the fully paired training dataset 70 of Figure 7 includes a first subset of training data 73 for process parameters $\theta_1$ and a second subset of training data 74 for process parameters $\theta_2$. The subset 73 includes metrology data items from $A^1, A^2, A^3$ from domain A (e.g. generated by using a respective metrology system to inspect portions/locations $i = 1, 2, 3$ of the patterned substrate. Data items $A^1, A^2, A^3$ are metrology data items (from domain A) of nominally identical structures (structures that have been manufactured according to the same target design) because the locations $i = 1, 2, 3$ have been patterned according to the same process parameter $\theta_1$. The subset 73 further includes, for each metrology data item from domain A, a corresponding metrology data item from domain B, namely $B^1, B^2, B^3$. This means that the metrology data items in subset 73 of Figure 7 form pairs $\{A^1, B^1\}$, $\{A^2, B^2\}$, $\{A^3, B^3\}$ of corresponding metrology data items. Similarly, the subset 74 includes the pairs $\{A^4, B^4\}$, $\{A^5, B^5\}$, $\{A^6, B^6\}$ of corresponding metrology data items.

The weakly paired training dataset 71 includes, for each set of values of the process parameters $\theta$, metrology data items from both domains without including corresponding metrology data items. As illustrated in Figure 7, the weakly paired training dataset 71 includes a subset of training data 75 for the process parameters $\theta_1$ which includes, from domain A, the metrology data item $A^2$ but not the metrology data items $A^1$ and $A^3$, and, from domain B, the metrology data items $B^1$ and $B^3$ but not the metrology data item $B^2$. In this case, the available metrology data item $A^2$ may be considered to be weakly linked to and the metrology data items $B^1$ and $B^3$, because although these metrology data items relate to different locations of the substrate, they all have both been generated by a common process defined by the process parameters $\theta_1$, e.g. $A^2, B^1$ and $B^3$ may relate to the same field of the wafer. Similarly, the weakly paired training dataset 71 includes a second subset of training data 76 for process parameters $\theta_2$ which includes, from domain A, the metrology data items $A^5$ and $A^6$ but not the metrology data item $A^4$ and, from domain B, the metrology data item $B^4$ but not the metrology data items $B^5$ and $B^6$, i.e. the items $A^5$ and $A^6$ can be considered to be weakly linked to item $B^4$ because of the common process parameters $\theta_2$.

The unpaired training dataset 72 includes, for each set of values of the process parameters $\theta$, either one or more metrology data items from domain A or B but not from both. As illustrated in Figure 7, the unpaired paired training dataset 72 includes a subset of training data 77 for the process parameters $\theta_1$ which includes the metrology data items $A^1, A^2, A^3$ but no metrology data item from domain B. Similarly, the subset of training data 78 for the process parameters $\theta_2$ includes the metrology data items $B^4, B^5, B^6$ but no metrology data item from domain A. Thus, the items $A^1, A^2, A^3$ and the items $B^4, B^5, B^6$ are "unpaired" since they have been generated by different process parameters (e.g. relate to different fields of the wafer).

A machine learning model, such as the above-described diffusion model, can be trained using a fully paired training data to perform the desired domain-to-domain mapping, e.g. by adjusting the parameters defining the model to accurately predict a metrology data item

$B^i$ from domain B given the corresponding metrology data item $A^i$ of domain A. However, for many applications, it is impossible, impractical and/or expensive to generate a fully paired dataset. In contrast, weakly paired and unpaired datasets are often easier to obtain and are more readily available. It is therefore desirable to provide techniques that enable the use of weakly paired and/or unpaired datasets for training a machine learning model to map metrology data between two domains.

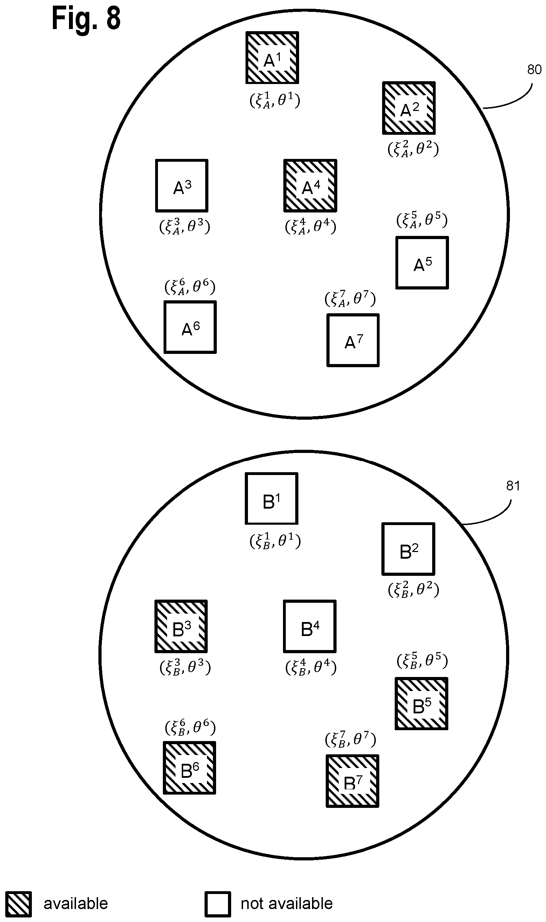

Before describing example embodiments (which can use fully paired, unpaired datasets weakly paired and unpaired datasets to train diffusion models for domain mapping), an example training data generation scenario is described with reference to Figure 8 in which (only) unpaired training metrology data items are generated. More specifically, Figure 8 illustrates a semiconductor wafer at a post-lithography (ADI) step of the manufacturing process (reference numeral 80), and at a subsequent post-etch (AEI) step (reference numeral 81). As illustrated in Figure 8, the wafer has been, at each of a plurality of locations (i = 1, ..., 7), processed according to a different set of process parameters $\theta_i$. Some but not all of the locations i = 1,..., 7 of the post-lithography wafer 80 have been inspected to generate corresponding metrology data items from domain A (i.e. $A^1$, $A^2$, $A^4$), i.e. the locations i = 3, 5, 6, 7 have not been inspected (e.g. because such an inspection would damage or destroy the substrate at these locations, because measuring all relevant locations would be too time intensive, etc.). The post-etch wafer 81 has been inspected at the locations i = 3, 5, 6, 7 to generate corresponding data items from domain B (i.e. $B^3$, $B^5$, $B^6$, $B^7$), i.e. the locations i = 1, 2, 4 have not been inspected (e.g. because the substrate has been damaged or destroyed at these locations by generating the domain A data items). Thus, in this scenario neither fully nor weakly paired data items are generated.

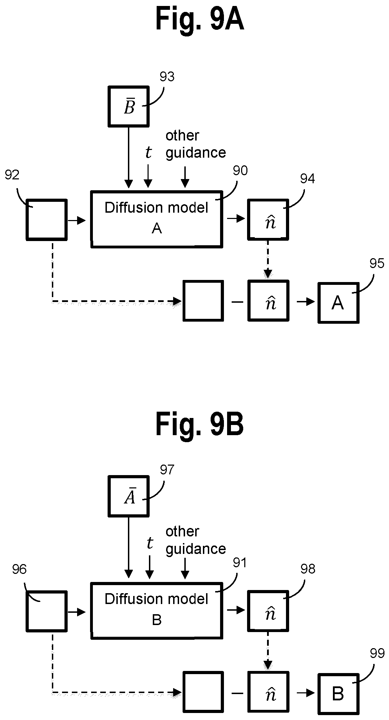

An example pair of diffusion models 90, 91 for domain mapping of metrology data is now described with reference to Figures 9A and 9B. Each of the diffusion models 90, 91 is a neural network defined by tuneable numerical parameters (e.g. at least 100, at least 1000, or more numerical parameters). Once trained, the diffusion model 90 (hereafter "diffusion model A") can be conditioned with metrology data (i.e. metrology data of a patterned portion of a substrate) from domain B, and used to process an input to generate corresponding predicted metrology data 95 from domain A. The generated predicted metrology data 95 from domain A is consistent with the metrology data from domain B used to condition the diffusion model 90, e.g. the predicted metrology data 95 from domain A may be the most likely metrology data from domain A given the metrology data from domain B.

Similarly, once trained, the diffusion model 91 (hereafter "diffusion model B") can be conditioned with metrology data (i.e. metrology data of a patterned portion of a substrate) from domain A, and used to process an input to generate corresponding predicted metrology data 99 from domain B. The generated predicted metrology data 99 from domain B is consistent with the metrology data from domain A used to condition the diffusion model 91, e.g. the predicted metrology data from domain B may be the most likely metrology data from domain B given the metrology data from domain A.

More specially, the diffusion model A 90 is configured and trained to receive, as input, i) an approximation 92 of to-be-predicted metrology data from domain A, ii) metrology data 93 from domain B, and iii) and an index t indicating a diffusion step number, and to generate, based on the input, a prediction $\hat{n}$ of noise present in the input data 92.

Optionally, the diffusion model A may be configured to receive further data as additional conditioning input ("other guidance" in Figure 9A), e.g. acquisition settings, process settings, other known parameters or prior information. For example, the diffusion model A may also receive, as additional conditioning input, configuration data $\zeta_B$ which specifies the metrology process associated with domain B (e.g. the configuration data $\zeta_B$ may, for example, identify a type of the metrology tool (e.g. a manufacturer designation of the model of the sensor), configuration data $\zeta_A$ which specifies the metrology process associated with domain A, and/or comprise data defining a calibration setting of the sensor(s) during the observation).

Similarly, the diffusion model B is configured and trained to receive, as input, i) an approximation 96 of to-be-predicted metrology data from domain B, ii) metrology data 97 from domain A, and iii) and an index t indicating a diffusion step number, and to generate, based on the input, a respective prediction $\hat{n}$ of noise present in the input data 96.

Optionally, the diffusion model B may be configured to receive further data as additional conditioning input ("other guidance" in Figure 9B). For example, the diffusion model B may also receive configuration data $\zeta_A$ which specifies the metrology process associated with domain A (e.g. the configuration data $\zeta_A$ may, for example, identify a type of the metrology tool (e.g. a manufacturer designation of the model of the sensor) and/or comprise data defining a calibration setting of the sensor(s) during the observation).

The metrology data that is used to condition the respective diffusion model (i.e. metrology data 93 or 97) may be generated using any suitable metrology system/tool (e.g. using HV-SEM, SEM, soft X-ray, etc.). It may include data generated by multiple sensors, e.g. of different types. It is also possible that the metrology data is generated from a plurality of metrology data items. For example, a pattern portion of a substrate may comprise a plurality of nominally identical targets for which a corresponding plurality of metrology data items are generated. In this case, the metrology data for conditioning the respective diffusion model may be generated based on statistical values obtained by statistical analysis of the metrology data items of the plurality of nominally identical targets. As one example, a "representative" metrology data item may be selected from metrology data items of the plurality of nominally identical targets based on the statistical values (e.g. the representative metrology data item may be selected as one having properties which obey a similarity criterion with respect to the statistical values, e.g. the metrology data item that is most similar to the other metrology data items of the plurality of nominally identical targets). As another example, the metrology data for conditioning the respective diffusion model may be generated as the mean or median of the metrology data items of the plurality of nominally identical targets (e.g. by taking an element-wise (e.g. pixel-wise in case of image-based metrology data items) mean or median of the metrology data items of the plurality of nominally identical targets). The metrology data 93, 97 may be denoted respectively with the symbols $\bar{B}, \bar{A}$ to indicate that the metrology data is generated from a plurality of metrology data items.

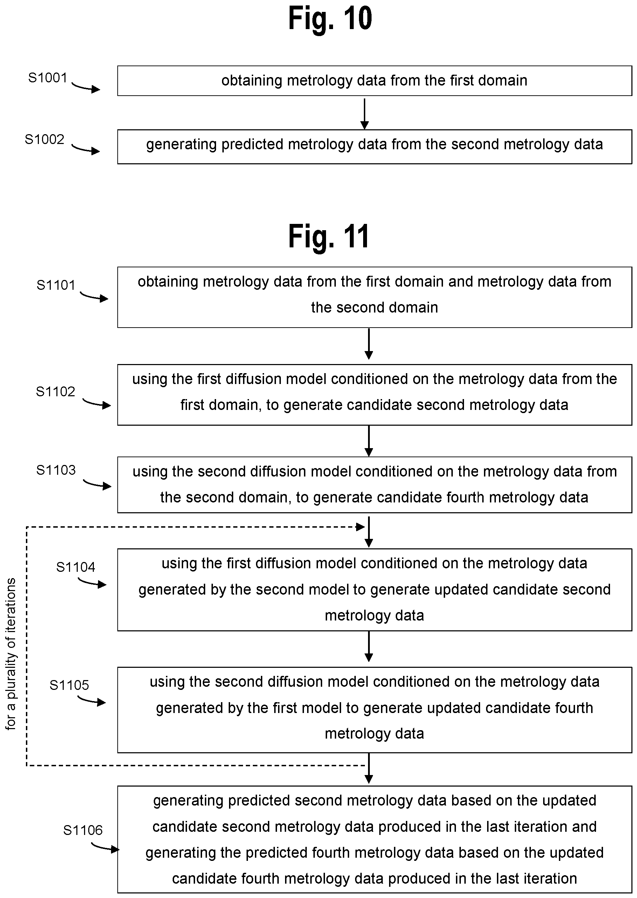

With reference to Figure 10, a first example process of using the trained diffusion model A to infer metrology data from domain A is now described. At an initial step S1001, first metrology data of a patterned portion of a substrate is obtained. The first metrology data comprises metrology data from domain B (e.g. metrology data $\bar{B}$ in Figure 9A). In some implementations, the first metrology data may be metrology data of a representative sample of a plurality of metrology data items generated for a plurality of nominally identical targets or otherwise generated from the plurality of metrology data items for a plurality of nominally identical targets (as described above).

At step S1002, predicted second metrology data from domain A is generated. Depending on the specific application, the predicted second metrology data may be a prediction of metrology data from domain A for the patterned portion of the substrate associated with the first metrology data or a corresponding patterned portion of the substrate (e.g. as described above, domain B may relate to scribe lane target and domain A to in-die targets). More specifically, the predicted second metrology data is generated based on the output of the diffusion model A conditioned on the first metrology data. In broad terms, this is achieved by "reversing" the diffusion process over one or more iterations. To this end, an initial guess of the second metrology data is formed (which may be random data, e.g. randomly selected values), to be used as an input 92 to the diffusion model A. The initial guess of the second metrology data corresponds to the "current candidate second metrology data" for the first iteration.

The trained diffusion model A is then applied at least once to "de-noise" the initial guess. The output of the diffusion model A is an estimate $\hat{n}$ ("noise data") of the noise in the input. This is removed from the initial guess to generate updated current candidate second metrology data. In the case that the trained diffusion model A is applied more than once (i.e. in multiple iterations), in each iteration (except the first) the diffusion model A receives as its input the current candidate second metrology data which has been updated based on the output of the diffusion model A in the previous iteration. This means that in each iteration, to generate the updated current candidate second metrology data, the diffusion model A is conditioned on (i.e. receives as an input) the first metrology data from domain B (and preferably on the index t and/or on the aforementioned further guidance data), and used to process the current candidate second metrology data, to generate (or predict) noise data $\hat{n}$ (which is indicative of a divergence between the current candidate second metrology data and metrology data of domain A which is more consistent with the first metrology data of domain B than the current candidate second metrology data). This is removed from the current candidate second metrology data to generate updated current candidate second metrology data. In this way, the diffusion model A may be applied multiple times until a termination criterion is met (e.g. convergence criterion is satisfied (e.g. the estimated noise $\hat{n}$ has a magnitude, according to a magnitude measure, below a threshold) or until a certain pre-defined number of iterations has been performed).

As a final result, the predicted second metrology data is generated and output (e.g. displayed to an operator, or transmitted to another computer system, or input to a control system of the wafer processing apparatus which produced the substrate). It is the best estimate produced by the method of ground truth metrology data from domain A that corresponds the first metrology data from domain B. The predicted second metrology data is based on the updated current second metrology data produced in the last iteration. For example, the updated current second metrology data produced in the last iteration may simply be provided as the final predicted second metrology data.

In some implementations, step S1002 may be performed a plurality of times, i.e. each time a new predicted second metrology data item is generated based on the same first metrology data and a different random initial guess of the second metrology data. The so-generated plurality of predicted second metrology data items provides an approximation of the distribution of metrology data items of domain A that are consistent with first metrology data from domain B. This approximated distribution is often more informative than a single sample, e.g. control signals for the wafer processing apparatus derived based on the plurality of predicted second metrology data items may be improved compared to control signals derived based on a single sample of the predicted second metrology data.

It is to be understood that the trained diffusion model B may be used to process metrology data from domain A to infer metrology data from domain B in a similar way as described above for diffusion model A with reference to Figure 10.

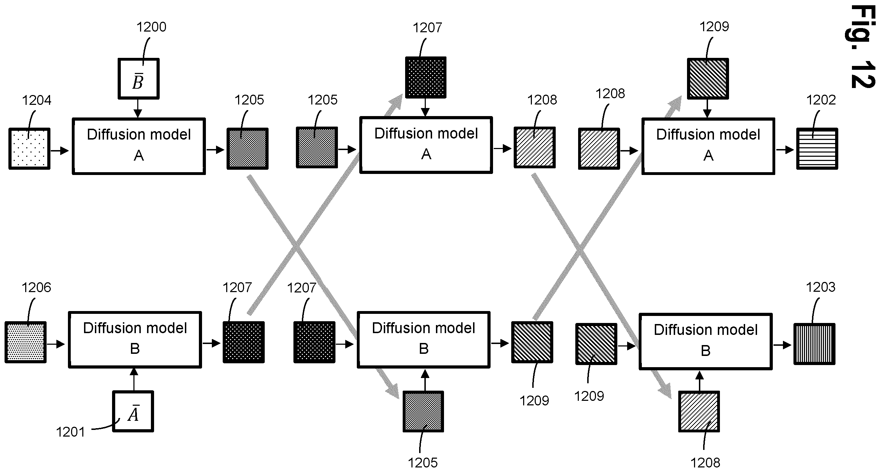

Thus, each diffusion model A/B may individually be used to predict a sample from domain A/B "guided" only by obtained metrology data from domain B/A (and optionally the aforementioned further guidance data). With reference to Figures 11 and 12, an example inference process is described, in which both diffusion models A and B are "cross-linked" to provide guidance to each other so as to generate a statistically correlated pair of predicted metrology data items from domains A and B. More specifically, Figure 11 shows a flow diagram of the process, and Figure 12 illustrates three iterations of the inference process.

At an initial step S1101, metrology data 1200 ("first metrology data") from domain B and metrology data 1201 ("third metrology data") from domain A is obtained. It is not necessary that the metrology data 1200 and the metrology data 1201 are associated with the same location of a wafer, i.e. that the metrology data 1200 and the metrology data 1201 form a corresponding pair $\{A^i, B^i\}$. Instead, the metrology data 1200 and the metrology data 1201 may relate to different locations of the wafer (e.g. $\{A^i, B^j\}$). The initially obtained metrology data 1200, 1201 may be generated from a plurality of metrology data items as noted before, denoted with the symbols $\bar{B}$ and $A$.

The metrology data 1200 and 1201 are then processed by the diffusion models A and B over a plurality of iterations to generate (statistically correlated) predicted metrology data 1202 ("second metrology data") from domain A and metrology data 1203 ("fourth metrology data") from domain B. At step S1102, an initial guess 1204 of the second metrology data 1202 is formed (which may be random data, e.g. randomly selected values), to be used as an input to the diffusion model A ("first diffusion model"). The initial guess 1204 corresponds to the "current candidate second metrology data" for the first iteration. Then, diffusion model A processes, conditioned on the first metrology data 1200, the initial guess 1204. Based on the output (i.e. predicted noise) of the diffusion model A, updated candidate second metrology data 1205 are generated (note that, for simplicity, this process is omitted from Fig. 12). Similarly, at step S1103, an initial guess 1206 of the fourth metrology data is formed (which may be random data, e.g. randomly selected values), to be used as an input to the diffusion model B ("second diffusion model"). The initial guess 1206 corresponds to the "current candidate fourth metrology data" for the first iteration. Then, diffusion model B processes, conditioned on the third metrology data 1201, the initial guess 1206. Based on the output (i.e. predicted noise) of the diffusion model B, updated candidate fourth metrology data 1207 are generated. Thus, in steps S1102 and S1103, the diffusion models A and B perform a first de-noising step of respectively initial guesses guided by the obtained metrology data 1200, 1201.

Next, steps S1104 and S1105 are performed for a plurality of iterations. At each step S1104, the diffusion model A performs a further de-noising step of the current candidate second metrology data. However, unlike in step 1102, in step S1104, the diffusion model A is not conditioned on the first metrology data 1200 but on the current candidate fourth metrology data generated in the previous iteration based on the output of diffusion model B. Similarly, at each step S1104, the diffusion model B performs a further de-noising step of the current candidate fourth metrology data. However, unlike in step 1103, in step S1105, the diffusion model B is not conditioned on the third metrology data 1201 but on the current candidate second metrology data generated in the previous iteration based on the output of diffusion model A. Figure 12 illustrates that in the second iteration updated current candidate second metrology data 1208 are generated by processing the current candidate second metrology data 1205 using the diffusion model A guided by (i.e. conditioned on) the current candidate fourth metrology data 1207 generated in the first iteration based on the output of diffusion model B. Similarly, in the second iteration updated current candidate fourth metrology data 1209 are generated by processing the current candidate fourth metrology data 1207 using the diffusion model B guided by (i.e. conditioned on) the current candidate second metrology data 1205 generated in the first iteration based on the output of diffusion model A.

The repeated provision of updated cross-guidance by the other diffusion model means that the predicted metrology data items iteratively converge on respective sample points from both domains that are statistically coupled. Finally, at step S1106, the predicted second and fourth metrology data 1202 and 1203 are generated based on the updated current second metrology data produced in the last iteration. For example, the updated current second and fourth metrology data produced in the last iteration may simply be provided as the final predicted second and fourth metrology data respectively. The predicted second and fourth metrology data 1202 and 1203 may be output (e.g. displayed to an operator, or transmitted to another computer system, or input to a control system of the wafer processing apparatus which produced the substrate).

As described above for the process with reference to Figure 10, the steps S1101 to S1106 may be performed for a plurality of times (until a termination criterion is met, e.g. a convergence criterion is satisfied or a predefined number of interactions has been performed) to obtain a corresponding plurality of predicted second and fourth metrology data items, i.e. the steps S1101 to S1106 are performed for the same first and third metrology data but for different initial guesses. The so-generated plurality of predicted second and fourth metrology data items represent an approximation of the joint distribution of the observed samples from the two domains.

Note that, in equivalent variations, the steps S1101 and S1102 may be performed in the other order or in parallel (i.e. at time which overlap with each other). Similarly, steps S1104 and S1105 may be performed in the other order or in parallel.

While in the process described above with reference to Figures 10 and 11, the diffusion models A and B are cross-linked to provide updated guidance to each other at each iteration and based only on output generated in the directly preceding iteration, it is to be understood that in other implementations, the diffusion models A and B may be differently cross-linked, e.g. the conditioning input of diffusion model A (B) may be based on the respective outputs of diffusion model B (A) generated for a plurality of previous iterations (e.g. a sliding average of the last five iterations or the like), and/or the conditioning input of diffusion model A (B) may not be updated for every iterations but only for a few iterations or just for one iteration.

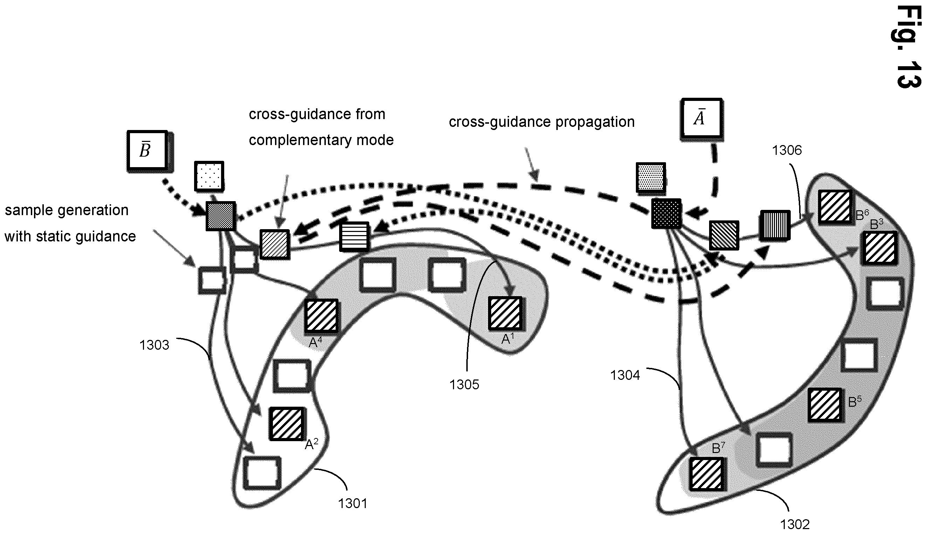

Figure 13 illustrates the processes of Figures 10 and 11 in which random initial guesses are iteratively denoised to obtain samples from domain A and/or domain B (the domain manifolds A and B are indicated by the reference numerals 1301 and 1302). More specifically, the reference numeral 1303 indicates a path representing the process of Figure 10, i.e. the generation of predicted metrology data from domain A through a reverse diffusion process with "static guidance" in form of the metrology data $\overline{B}$. Reference numeral 1304 indicates a path respecting the complementary process of 1303, i.e. the generation of metrology data from domain B through a reverse diffusion process with "static guidance" in form of the metrology data $A$. Reference numerals 1305 and 1306 illustrate the process of Figure 11 in which a correlated pair of predicted metrology data items from domains A and B is generated through cross-linking of the reverse diffusion processes.

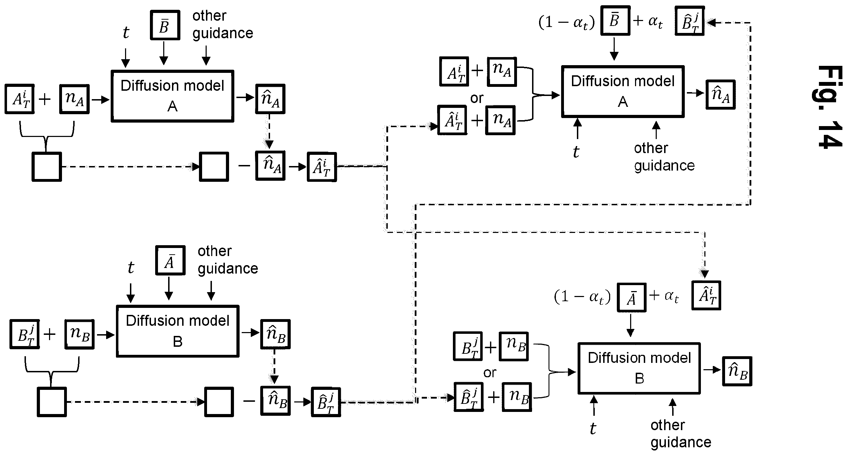

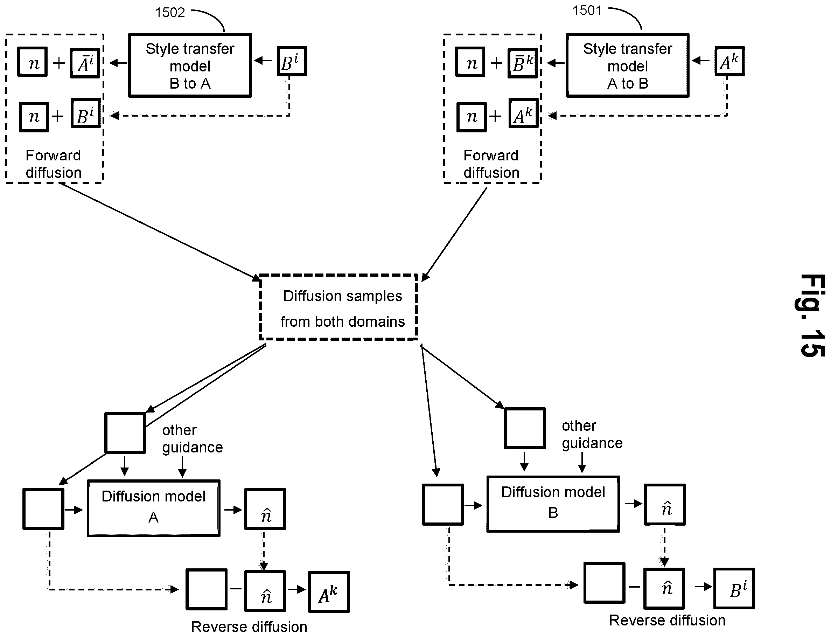

Diffusion models A and B of Figure 9A and 9B may be trained using training dataset of fully paired metrology data items. However, as noted above, fully paired training data items are often not available. It is therefore desirable to provide techniques for training the diffusion models A and B using weakly and/or unpaired training data items. With reference to Figure 14, an example training process for jointly training the diffusion models A and B of Figure 9A and 9B using weakly paired training data items will now be described. A further example training process for jointly training the diffusion models A and B of Figure 9A and 9B using unpaired training data items is described below with reference to Figure 15.

In broad terms, the example training process of Figure 14 implements a joint training of the diffusion model A (to learn to predict a sample from domain A given an example from domain B) and the diffusion model B (to learn to predict a sample from domain B given an example from domain A) using cross-linked diffusion which allows the use of weakly paired training data items.

More specifically, the diffusion model A and the diffusion model B are trained using a training database comprising a plurality of training metrology data items from domain (e.g. metrology data item $A_T^i$ indicated in Figure 14 where the index "i" indicates the i-th location of the patterned portion, and the index "T" indicates that the metrology data item is part of the training database) and a plurality of training metrology data items from domain B (e.g. metrology data item $B_T^j$ of Figure 14 which relates to the j-th location of the patterned portion). The training metrology data items from domain A and training metrology data items from domain B are weakly paired, i.e. the training metrology data items from domain A and training metrology data items from domain B belong to the same configurations of the process parameters $\theta$ but relate to different (but nominally identical) locations of the patterned portion of the substrate (e.g. for ADI to AEI mapping, the training metrology data items from domain A/B may be relate to the same relative location of two different fields of the wafer, or to two different locations within the same field).

The training process may involve a plurality of training steps where in each training step one of the training items from domain A and one of the training items from domain B is processed by the diffusion models. Each training step involves performing cross-linked diffusion over a plurality of iterations. Figure 14 illustrates two iterations of a training step in which the training metrology data items $A_T^i$ and $B_T^j$ are processed.

More specifically, at a first iteration of the training step, a perturbation "$n_A$" (e.g. random noise) is applied to the training metrology data item $A_T^i$ to generate a perturbed training metrology data item. The diffusion model A, conditioned on metrology data $\overline{B}$ from domain B and preferably on the index t and/or on the aforementioned other guidance data, processes the perturbed training metrology data item to predict the introduced perturbation $\hat{n}_A$ (i.e. an estimate of the noise $n_A$). The predicted perturbation $\hat{n}_A$ is then removed from the perturbed training metrology data item to generate denoised metrology data $\hat{A}_T^i$. The metrology data $\overline{B}$ from domain B on which the diffusion model A is conditioned in the first iteration may be generated from the training metrology data items from domain B as described above, e.g. $\overline{B}$ may be one of the training metrology data items from domain B (e.g. a representative example) or may be generated based on a mean or median of the training metrology data items from domain B. In an analogues manner, the training metrology data item $B_T^j$ is perturbed with respective noise $n_B$, and the diffusion model B processes, conditioned on metrology data $\overline{A}$ from domain A and preferably on the index t and/or on the aforementioned other guidance data, the perturbed training metrology data item to predict the introduced perturbation $\hat{n}_B$ (i.e. an estimate of the noise $n_B$). The predicted perturbation $\hat{n}_B$ is then removed from the perturbed training metrology data item to generate de-noised metrology data $\hat{B}_T^j$. The metrology data $\overline{A}$ from domain A on which the diffusion model B is conditioned in the first iteration may be generated from the training metrology data items from domain A as described above.

In iterations of the training step that follow the first iteration, the diffusion models are cross-linked, i.e. diffusion model A is conditioned based on a combination of the metrology data $\overline{B}$ and the de-noised metrology data $\hat{B}_T^j$ generated in the previous iteration based on the output of the diffusion model B, and diffusion model A is conditioned based on a combination of the metrology data $\overline{A}$ and the de-noised metrology data item $\hat{A}_T^i$ generated in the previous iteration based on the output of the diffusion model A. The metrology data $\overline{B}$ (or $\overline{A}$) and the de-noised metrology data $\hat{B}_T^j$ (or $\hat{A}_T^i$) may be combined in any suitable manner, e.g. as a linear combination (i.e. a weighted sum). The metrology data $\overline{B}$ (or $\overline{A}$) and the de-noised metrology data $\hat{B}_T^j$ (or $\hat{A}_T^i$) may be combined as a weighted sum where the weights of the weighted sum depend on the respective iteration (i.e. on the index t), e.g. so as to gradually increase the weight of the de-noised metrology data $\hat{B}_T^j$ (or $\hat{A}_T^i$) for increasing iterations. For example, the metrology data $\overline{B}$ and the de-noised metrology data $\hat{B}_T^j$ may be linearly combined based on the expression $(1 - \alpha_t)\overline{B} + \alpha_t \hat{B}_T^j$ where the iteration-dependent parameter $\alpha_t (\alpha_t \in [0,1])$ controls the relative weights of the metrology data $\overline{B}$ and the de-noised metrology data $\hat{B}_T^j$. Similarly, the metrology data $\overline{A}$ and the de-noised metrology data item $\hat{A}_T^i$ may be linearly combined based on the expression $(1 - \alpha_t)\overline{A} + \alpha_t \hat{A}_T^i$. The parameter $\alpha_t$ may be dependent (e.g. proportional) to a ratio of the current value of the iteration index t and a parameter $t_{max}$ that indicates the maximum number of iterations per training step.

In each iteration (except the first one) of the training step, a respective perturbation $n_A$ is applied to the de-noised metrology data $\hat{A}_T^i$ generated in the previous iteration to generate a respective perturbed metrology data item to be used as input to the diffusion model A for the iteration (as illustrated in Figure 14, in some implementations, the perturbation $n_A$ may be applied to the training metrology data item $A_T^i$ to generate a respective perturbed metrology data item to be used as input to the diffusion model A for the iteration). As shown in Figure 14, the respective input to the diffusion model B may be generated in an analogous manner.

Thus, in each iteration (except the first one) of the training step, the diffusion models A and B process, guided by the other diffusion model, respective perturbed metrology data items generated for the iteration.

Further, for each iteration of the training step, one or more numerical parameters of the diffusion models A and B are iteratively modified (i.e. updated) to reduce i) a measure of the divergence (e.g. the difference) between the applied perturbation $n_A$ for the iteration and the predicated perturbation $\hat{n}_A$ for the iteration, and ii) a measure of the divergence (e.g. the difference) between the applied perturbation $n_B$ for the iteration and the predicated perturbation $\hat{n}_B$ for the iteration (which may be equivalent to reducing a measure of the divergence between the respective input metrology data for the iteration before applying the noise perturbation and the respective de-noised metrology data for the iteration).

It is to be understood that in some implementations, the training database may comprise, for each of a plurality of configurations of the process parameters $\theta$, a respective training database subset comprising respective weakly paired training items, and the above training process may be performed for each training database subset.

A variation of the above described training process in which unpaired training metrology data can be used to (further) train the diffusions model A and B will now be described with reference to Figure 15. In this case, the training database for training the diffusion models comprises a plurality of training metrology data items from domain A generated for a first configuration of the process parameters $\theta$, and a plurality of training metrology data items from domain B generated for a second (i.e. different) configuration of the process parameters $\theta$ (i.e. the training metrology data items from domain A and the training metrology data items from domain B are unpaired).

Similar to the training process described above with reference to Figure 14, the training is performed over a plurality of training steps where in each training step a training metrology data item from domain A and a training metrology data item from domain B are processed, over a plurality of iterations, by cross-linked diffusion models A and B. Unlike the training process of Figure 14, the training process of Figure 15 uses trained style transfer models to generate the conditioning metrology data for the first iteration. More specifically, the training process of Figure 15 uses a first style transfer model 1501 configured to process metrology data from domain A to predict corresponding metrology data from domain B, and a second style transfer model 1502 configured to process metrology data from domain B to predict corresponding metrology data from domain A. Each of the style transfer models 1501, 1502 is a neural network defined by tuneable numerical parameters (e.g. at least 100, at least 1000, or more numerical parameters).

The style transfer models 1501, 1502 may generate the predicted metrology data based on characteristics associated with the target domain (i.e. according to a "style" associated with the target domain). This means that metrology data items predicted by the style transfer models 1501, 1502 generally "look" like metrology data from the target domain without necessarily being an accurate prediction given the input metrology data. The style transfer models 1501, 1502 may be "smaller" models compared to the diffusion models A and B, i.e. the style transfer models 1501, 1502 may be defined by a significantly smaller number of learnable parameters (e.g. less than 10%). As a simplified example, when both domains relate to image-based metrology data, and a mean intensity of images from domain B is 10 higher than a mean intensity of images from domain A, the image predicted by the first style transfer model 1501 may correspond to the input image but with a 10-fold increase of the pixel value.

Thus, in each training step, a training metrology data item from domain A (e.g. $A^k$) and a training metrology data item from domain B (e.g. $B^i$) are processed. The training metrology data item $A^k$ is processed using the first style transfer model 1501 to generate a predicted training metrology data item from domain B (e.g. $\overline{B}^k$), and the training metrology data item $B^i$ is processed using the second style transfer model 1502 to generate a predicted training metrology data item from domain A (e.g. $\overline{A}^i$). The output from the style transfer models may be used via a forward diffusion process (e.g. by applying noise) to define the inputs (conditioning inputs and/or diffusion inputs) for the diffusion models in the first iteration of a cross-linked training step as described above with reference to Figure 14. In some implementations, the style transfer models jointly trained with the diffusion models A and B (e.g. the may be pre-trained the style transfer models and may be further trained jointly with the diffusion models A and B).

In some implementations, the diffusion models A and B may be first pre-trained using weakly paired training metrology data (as described above with reference to Figure 14), and then further trained using unpaired training metrology data as described with reference to Figure 15.

Many ways of training the style transfer models exist. One possibility is to train the style transfer models individually based on a training database comprising paired metrology data. Another possibility is to jointly train the first and second style transfer model, e.g. using a cycle generative adversarial network and a training database of training items which each comprise training metrology data from domain A, and corresponding training metrology data from domain B. The cycle generative adversarial network comprises (as generators) the first and second style transfer models, a first discriminator model configured to discriminate between the output of the first style transfer model generated when processing training metrology data from the first metrology domain and the corresponding training metrology data from the second metrology domain, and a second discriminator model configured to discriminate between the output of the second style transfer model generated when processing the output of the first style transfer model and the corresponding training metrology data.

A further possibility is to use the diffusion models A and B (e.g. pre-trained on weakly paired training items) for the training of the style transfer models (once trained, the style transfer models can be used to further train the diffusion models A and B as described above). In this case, a training database may be used that comprises a plurality of training metrology data items from domain B. The training may comprise, for each training metrology data item, obtaining a cyclic loss by processing the training metrology data item using the second style transfer model to generate predicted metrology data from domain A, and then processing the predicted metrology data from domain A using the first style transfer model to generate predicted metrology data from domain B. Then, the cyclic loss is determined based on a divergence between the training metrology data item and the predicted metrology data from domain B. Next, a diffusion loss is obtained by generating based on the output of diffusion model B, when conditioned on the predicted metrology data from domain generated A, for the training item, by the second style transfer model, respective output metrology data for the training item, by determining the diffusion loss based on a divergence between the training metrology data item and the corresponding output metrology data generated based on the output of diffusion model B. Then, one or more numerical parameters of the first and second style transfer models are updated based on the cyclic loss and the diffusion loss (e.g. to reduce the value of a combined loss function based on (e.g. equal to) a sum of the cyclic loss and the diffusion loss).

Further embodiments are disclosed in the subsequent numbered clauses:

1. A computer-implemented method of processing first metrology data of a patterned portion of a substrate patterned using a wafer processing apparatus to generate predicted second metrology data of the, or another corresponding, patterned portion of the substrate, the first metrology data comprising metrology data from a first metrology domain which obtains metrology data using a first metrology process;

the method comprising:

i) obtaining the first metrology data of the patterned portion of the substrate, and
ii) generating predicted second metrology data of the patterned portion of the substrate, or of the corresponding patterned portion of the substrate, based on the output of a first trained diffusion model conditioned on the first metrology data, the predicted second metrology data comprising predicted metrology data from a second metrology domain which obtains metrology data using a second metrology process.

2. The method of clause 1, wherein the first diffusion model has been trained based on the output of the first diffusion model conditioned metrology data in the first metrology domain generated based on the output of a second trained diffusion model conditioned on training metrology data from the second metrology domain.

3. The method of clause 1 or 2, wherein the first trained diffusion model conditioned on the first metrology data processes an input data item, and step (ii) is performed a plurality of times using different respective randomly selected input data items to generate a corresponding plurality of corresponding items of predicted second metrology data.

4. The method of any preceding clause, wherein generating predicted second metrology data of the patterned portion or the corresponding patterned portion of the substrate based on the output of a first trained diffusion model conditioned on the first metrology data comprises:

at least one iteration of:

processing, by the first diffusion model conditioned on the first metrology data, an input to the first diffusion model comprising current candidate second metrology data, and based on the output of the first diffusion model generating updated candidate second metrology data; and

generating the predicted second metrology data based on the updated candidate second metrology data produced in the last iteration.

5. The method of any of clauses 1-3, further comprising obtaining third metrology data of the patterned portion, or the corresponding patterned portion, the third metrology data comprising metrology data from the second metrology domain; and wherein step ii) comprises:

for each of a plurality of iterations:

(a) processing, by the first diffusion model conditioned on respective conditioning metrology data for the iteration, an input to the first diffusion model comprising current candidate second metrology data, (b) based on the output of the first diffusion model generating updated candidate second metrology data; and

generating the predicted second metrology data based on the updated candidate second metrology data produced in the last iteration,

wherein, for an initial iteration, the conditioning metrology data for the iteration is the first metrology data, and for at least one subsequent iteration, the conditioning metrology data for the iteration is generated based on the output of a second diffusion model conditioned on the third metrology data.

6. The method of clause 5, wherein each of the plurality of iterations further comprises:

(c) processing, by the second diffusion model conditioned on respective conditioning metrology data for the iteration, an input to the second diffusion model comprising current candidate fourth metrology data from the first metrology domain,
(d) based on the output of the second diffusion model generating updated candidate fourth metrology data from the first metrology domain;

and the method further comprises generating predicted fourth metrology data from the first metrology domain based on the updated candidate fourth metrology data produced in the last iteration, wherein, for the initial iteration, the second diffusion model is conditioned on the third metrology data, and for each subsequent iteration, the first diffusion model is conditioned on the updated candidate fourth metrology data generated for a previous iteration, and the second diffusion model is conditioned on the updated candidate second metrology data generated for a previous iteration.

7. The method of clause 6, wherein said previous iteration is the directly preceding iteration.

8. The method of clause 6 or clause 7, wherein for each subsequent iteration, the first diffusion model is conditioned on conditioning metrology data generated from a plurality of items of updated candidate fourth metrology data generated in a corresponding plurality of previous iterations, and the second diffusion model is conditioned on conditioning metrology data generated from a plurality of items of updated candidate second metrology data generated in a corresponding plurality of previous iterations.

9. The method of any preceding clause further comprising a step of processing the predicted second metrology data to generate one or more control actions for controlling the wafer processing apparatus to pattern additional substrates or to further pattern said substrate.

10. The method of any preceding clause, when dependent on clause 8, further comprising a step of processing the predicted fourth metrology data to generate one or more control actions for controlling the wafer processing apparatus to pattern additional substrates or to further pattern said substrate.

11. The method of any preceding clause, wherein the patterned portion of the substrate comprises a plurality of nominally identical targets, and the first metrology data is obtained by obtaining a respective metrology data item for each of the plurality of nominally identical targets, and determining the first metrology data is generated based on the metrology data items of the plurality of nominally identical targets.

12. The method of clause 11, wherein the first metrology data is generated based on statistical values obtained by statistical analysis of the metrology data items of the plurality of nominally identical targets.

13. The method of clause 12, wherein the first metrology data is one of the metrology data items of the plurality of nominally identical targets which is selected based on the statistical values.

14. The method of clause 13, wherein the first metrology data is selected as one having properties which obey a similarity criterion with respect to the statistical values.

15. The method of clause 12, wherein the first metrology data is generated based on a mean or median of the metrology data items of the plurality of nominally identical targets.

16. The method of any one of clauses 1 to 10, wherein the patterned portion of the substrate comprises a plurality of nominally identical targets, and the first metrology data is metrology data for one of the plurality of nominally identical targets.

17. The method of any preceding clause, wherein the first metrology data is metrology data of the patterned portion of the substrate at earlier step during a manufacturing process, and the predicted second metrology data is a prediction of metrology data of the or a corresponding patterned portion at a later step during the manufacturing process.

18. The method of clause 17, wherein the earlier step is an after development inspection step, the later step is an after etch inspection step.

19. The method of any preceding clause, wherein the first metrology data is metrology data of the patterned portion of the substrate generated by inspecting the patterned portion using a first metrology system, and the predicted second metrology data is a prediction of metrology data which would have been generated by inspecting the patterned portion using a second metrology system.

20. The method of clause 19, wherein the first metrology system is an optical metrology system, and the second metrology system is an electron-beam metrology system.

21. The method of any preceding clause, wherein the first metrology system is a metrology system in a first configuration, and the second metrology system is the first metrology system or a further metrology system in a second configuration different from the first configuration.

22. The method of clause 21, wherein the first configuration of the metrology system specifies a first wavelength of the metrology system, and the second configuration of the metrology system specifies a second wavelength of the metrology system or the further metrology system.

23. The method of any one of clauses 1 to 18, wherein the first metrology data is metrology data of a first patterned portion of the substrate, and the predicted second metrology data is a prediction of a second patterned portion of the substrate.

24. The method according to clause 23 in which the first and second patterned portion of the substrate were fabricated based on the identical design data.

25. The method of any preceding clause, wherein the first metrology data comprises image data.

26. The method of any preceding clause, wherein the first metrology data comprises after development inspection data or after etching inspection data.

27. The method of any preceding clause in which the wafer processing apparatus is a lithographic apparatus.

28. The method of any of clauses 1 to 27 in which the wafer processing apparatus is an etching apparatus.

29. The method of any of clauses 1 to 27 in which the wafer processing apparatus is a deposition apparatus.

30. A method of jointly training a first and a second diffusion model, the first diffusion model being trained to process, when the first diffusion model is conditioned on metrology data from a first metrology domain comprising metrology data obtainable by using a first metrology process, input metrology data from a second metrology domain comprising metrology data obtainable by using a second metrology process to generate noise data indicative of a divergence between the input metrology data and predicted metrology data from the second metrology domain, and

the second diffusion model being trained to process, when the second diffusion model is conditioned on metrology data from the second metrology domain, input metrology data from the first metrology domain to generate respective noise data indicative of a divergence between the respective input metrology data and predicted metrology data from the first metrology domain,
using a training database of training items which each comprises a tuple comprising training metrology data from the first metrology domain for a patterned portion of a substrate patterned using a wafer processing apparatus, and training metrology data from the second metrology domain for a nominally identical patterned portion of the said substrate;
the method comprising, for each tuple, performing a plurality of iterations, at each iteration:

processing, by the first diffusion model conditioned on respective conditioning metrology data for the iteration, respective input metrology data for the iteration and generating respective output metrology data for the iteration based on the output of the first trained diffusion model;

processing, by the second diffusion model conditioned on respective conditioning metrology data for the iteration, respective input metrology data for the iteration and generating respective output metrology data for the iteration based on the output of the second trained diffusion model,

iteratively modifying one or more numerical parameters of the first and the second diffusion model to reduce i) a measure of the divergence between the input metrology data and the output metrology data for the iteration for the first diffusion model, and ii) a measure of the divergence between the input metrology data and the output metrology data for the iteration for the second diffusion model, wherein, the input metrology data for the first diffusion model comprises the metrology data from the first metrology domain for the tuple or the output metrology data generated based on the output of the first diffusion model for a previous iteration, and the input metrology data for the second diffusion model comprises the metrology data from the second metrology domain for the tuple or the output metrology data generated based on the output of the second diffusion model for a previous iteration, and

wherein, at least for one iteration, the conditioning metrology data for the first diffusion model is generated based on the output of the second diffusion model for a previous iteration, and the conditioning metrology data for the second diffusion model is generated based on the output of the first diffusion model for a previous iteration.

31. The method of clause 30, wherein the conditioning metrology data for the first diffusion model is generated based on a combination of the metrology data from the first metrology domain for the tuple and the output of the second diffusion model for a previous iteration, and wherein the conditioning metrology data for the second diffusion model is generated based on a combination of the metrology data from the second metrology domain for the tuple and the output of the first diffusion model for a previous iteration.

32. The method of clause 31, wherein the conditioning metrology data for the first diffusion model is generated based on a weighted sum of the metrology data from the first metrology domain for the tuple and the output of the second diffusion model for a previous iteration, and

wherein the conditioning metrology data for the second diffusion model is generated based on a weighted sum of the metrology data from the second metrology domain for the tuple and the output of the first diffusion model for a previous iteration.

33. The method of clause 32, wherein the weights of the weighted sums depend on the respective iteration.

34. The method of any one of clauses 31 to 33, wherein, for at least one training item, the tuple comprises training metrology data from the second metrology domain that is generated by processing the corresponding training metrology data from the first metrology domain with a style transfer model configured to process metrology data from the first metrology domain to predict corresponding metrology data from the second metrology domain.

35. The method of clause 34, wherein the style transfer model is jointly trained with the first and second diffusion models.

36. A method according to clause 34 or clause 35 in which the style transfer model has been trained using a training database of training items which each comprise training metrology data from the first metrology domain for a patterned portion of a substrate patterned using a wafer processing apparatus, and corresponding training metrology data from the second metrology domain,

the training of the style transfer model comprising, for each training item, performing a plurality of iterations, at each iteration:

processing, by the style transfer model, the metrology data from the first metrology domain for the iteration to predict corresponding metrology data from the second metrology domain, and iteratively modifying one or more numerical parameters of the style transfer model to reduce a measure of the divergence between the metrology data predicted by the style transfer model and the corresponding training metrology data from the second metrology domain for the iteration.

37. A method according to clause 34 or clause 35 in which the style transfer model is a first style model which was jointly trained with a second style transfer model, the second style transfer model being trained to process metrology data from the second metrology domain to predict corresponding metrology data from the first metrology domain,

the joint training of the first and second style transfer models using a training database of training items which each comprise training metrology data from the first metrology domain for a patterned portion of a substrate patterned using a wafer processing apparatus, and corresponding training metrology data from the second metrology domain, and wherein the joint training is implemented using a cycle generative adversarial network comprising:

as generators, the first and second style transfer models;

a first discriminator model configured to discriminate between the output of the first style transfer model generated when processing training metrology data from the first metrology domain and the corresponding training metrology data from the second metrology domain, and

a second discriminator model configured to discriminate between the output of the second style transfer model generated when processing the output of the first style transfer model and the corresponding training metrology data from the first metrology domain.

38. A method of jointly training a first style transfer model and a second style transfer model, the first style transfer model being trained to process metrology data from a first metrology domain, which obtains metrology data using a first metrology process, to predict corresponding metrology data from a second metrology domain which obtains metrology data using a second metrology process, the second style transfer model being trained to process metrology data from the second metrology domain to predict corresponding metrology data from the first metrology domain,

the method using a first, the first diffusion model being configured to process, when the first diffusion model is conditioned on metrology data from the first metrology domain, input metrology data from a second metrology domain to generate noise data indicative of a divergence between the input metrology data and predicted metrology data from the second metrology domain, and

using a training database comprising a plurality of training items comprising training metrology data from the second metrology domain for a patterned portion of a substrate patterned using a wafer processing apparatus;

the method comprising, for each training item:

obtaining a cyclic loss by:

(a) processing the training metrology data for the training item using the second style transfer model to generate predicted metrology data from the first metrology domain;

(b) processing the predicted metrology data from the first metrology domain using the first style transfer model to generate predicted metrology data from the second metrology domain, and

(c) determining the cyclic loss based on a divergence between the training metrology data for the training item and the predicted metrology data from the second metrology domain;

obtaining a diffusion loss by:

(i) generating based on the output of the first diffusion model, when conditioned on the predicted metrology data from the first metrology domain generated, for the training item, by the second style transfer model, respective output metrology data for the training item;

(ii) determining the diffusion loss based on a divergence between the training metrology data for the training item and the corresponding output metrology data generated based on the output of the first diffusion model; and

modifying one or more numerical parameters of the first and second style transfer models based on the cyclic loss and the diffusion loss.

39. The method of clause 38 further comprising, for each training item, modifying one or more numerical parameters of the first diffusion model based on the diffusion loss.

40. The method of clauses 34 or clause 35 in which the style transfer model is the first transfer model trained in clause 38 or clause 39.

41. A computer program product comprising machine-readable instructions which, when the program is executed by a computer, cause the computer to carry out the method of any preceding clause.

42. A computer system comprising a processor and a data storage device, the data storage device storing program instructions which, when executed by the processor, cause the processor to carry out the method of any one of clauses 1 to 40.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A computer-implemented method of processing first metrology data of a patterned portion of a substrate patterned using a wafer processing apparatus to generate predicted second metrology data of the, or another corresponding, patterned portion of the substrate, the first metrology data comprising metrology data from a first metrology domain which obtains metrology data using a first metrology process;
   the method comprising:

   i) obtaining the first metrology data of the patterned portion of the substrate, and
   ii) generating predicted second metrology data of the patterned portion of the substrate, or of the corresponding patterned portion of the substrate, based on the output of a first trained diffusion model conditioned on the first metrology data, the predicted second metrology data comprising predicted metrology data from a second metrology domain which obtains metrology data using a second metrology process.

2. The method of claim 1, wherein the first diffusion model has been trained based on the output of the first diffusion model conditioned metrology data in the first metrology domain generated based on the output of a second trained diffusion model conditioned on training metrology data from the second metrology domain.

3. The method of any preceding claim further comprising a step of processing the predicted second metrology data to generate one or more control actions for controlling the wafer processing apparatus to pattern additional substrates or to further pattern said substrate.

4. The method of any preceding claim, wherein the patterned portion of the substrate comprises a plurality of nominally identical targets, and the first metrology data is obtained by obtaining a respective metrology data item for each of the plurality of nominally identical targets, and determining the first metrology data is generated based on the metrology data items of the plurality of nominally identical targets.

5. The method of any one of claims 1 to 3, wherein the patterned portion of the substrate comprises a plurality of nominally identical targets, and the first metrology data is metrology data for one of the plurality of nominally identical targets.

6. The method of any preceding claim, wherein the first metrology data is metrology data of the patterned portion of the substrate at earlier step during a manufacturing process, and the predicted second metrology data is a prediction of metrology data of the or a corresponding patterned portion at a later step during the manufacturing process.

7. The method of claim 6, wherein the earlier step is an after development inspection step, the later step is an after etch inspection step.

8. The method of any preceding claim, wherein the first metrology data is metrology data of the patterned portion of the substrate generated by inspecting the patterned portion using a first metrology system, and the predicted second metrology data is a prediction of metrology data which would have been generated by inspecting the patterned portion using a second metrology system.

9. The method of claim 8, wherein the first metrology system is an optical metrology system, and the second metrology system is an electron-beam metrology system.

10. The method of any preceding claim, wherein the first metrology system is a metrology system in a first configuration, and the second metrology system is the first metrology system or a further metrology system in a second configuration different from the first configuration.

**11.** The method of claim 10, wherein the first configuration of the metrology system specifies a first wavelength of the metrology system, and the second configuration of the metrology system specifies a second wavelength of the metrology system or the further metrology system.

**12.** The method of any one of claims 1 to 7, wherein the first metrology data is metrology data of a first patterned portion of the substrate, and the predicted second metrology data is a prediction of a second patterned portion of the substrate.

**13.** The method of any preceding claim in which the wafer processing apparatus is a lithographic apparatus, an etching apparatus, or a deposition apparatus.

**14.** A computer program product comprising machine-readable instructions which, when the program is executed by a computer, cause the computer to carry out the method of any preceding claim.

**15.** A computer system comprising a processor and a data storage device, the data storage device storing program instructions which, when executed by the processor, cause the processor to carry out the method of any one of claims 1 to 13.

# Fig. 1

# Fig. 2

EP 4 776 067 A1

# Fig. 3

# Fig. 4

# Fig. 5

SM1

2

5

Z

X

W

11

PU

4

6

I

λ

Z

8

X

# Fig. 6

# Fig. 7

available    not available

Fig. 8

available     not available

# Fig. 9A

# Fig. 9B

# Fig. 10

S1001 → | obtaining metrology data from the first domain |

↓

S1002 → | generating predicted metrology data from the second metrology data |

# Fig. 11

S1101 → | obtaining metrology data from the first domain and metrology data from the second domain |

↓

S1102 → | using the first diffusion model conditioned on the metrology data from the first domain, to generate candidate second metrology data |

↓

S1103 → | using the second diffusion model conditioned on the metrology data from the second domain, to generate candidate fourth metrology data |

↓

for a plurality of iterations

S1104 → | using the first diffusion model conditioned on the metrology data generated by the second model to generate updated candidate second metrology data |

↓

S1105 → | using the second diffusion model conditioned on the metrology data generated by the first model to generate updated candidate fourth metrology data |

↓

S1106 → | generating predicted second metrology data based on the updated candidate second metrology data produced in the last iteration and generating the predicted fourth metrology data based on the updated candidate fourth metrology data produced in the last iteration |

**Fig. 12**

Fig. 13

cross-guidance from
complementary mode

cross-guidance propagation

$\bar{A}$

$\bar{B}$

1306

sample generation
with static guidance

1303

A⁴

A¹

A²

1305

1304

B⁶

B³

B⁵

B⁷

1301

1302

## Fig. 14

# Fig. 15

**EUROPEAN SEARCH REPORT**

Application Number

EP 25 15 0768

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2021/140502 A1 (NOVA MEASURING INSTR LTD [IL]) 15 July 2021 (2021-07-15) * the whole document * ----- | 1-15 | INV. G03F7/00 |

TECHNICAL FIELDS SEARCHED (IPC)

G03F

The present search report has been drawn up for all claims

| Place of search | Date of completion of the search | Examiner |
|---|---|---|
| Munich | 24 June 2025 | Meixner, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                              

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 0768

This annex lists the patent family members relating to the patent documents cited in the above-mentioned European search report.
The members are as contained in the European Patent Office EDP file on
The European Patent Office is in no way liable for these particulars which are merely given for the purpose of information.

24-06-2025

| Patent document cited in search report | Publication date | Patent family member(s) | Publication date |
|---|---|---|---|
| WO 2021140502 A1 | 15-07-2021 | CN 114930117 A | 19-08-2022 |
| | | IL 294540 A | 01-09-2022 |
| | | KR 20220123301 A | 06-09-2022 |
| | | TW 202134925 A | 16-09-2021 |
| | | TW 202401287 A | 01-01-2024 |
| | | US 2023023634 A1 | 26-01-2023 |
| | | WO 2021140502 A1 | 15-07-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 2007224518 A
- US 2019003988 A1
- US 2019215940 A1
- US 20130304424 A1
- US 2014019097 A1, Bakeman

**Non-patent literature cited in the description**

- **LEMAILLET et al.** Intercomparison between optical and X-ray scatterometry measurements of FinFET structures. *Proc. of SPIE*, 2013, 8681